## Europäisches Patentamt
## European Patent Office
## Office européen des brevets

(19)

(11) Publication number: **0 011 964**
**B1**

(12) **EUROPEAN PATENT SPECIFICATION**

(45) Date of publication of patent specification: **05.09.84**

(51) Int. Cl.³: **H 01 L 27/06**

(21) Application number: **79302574.3**

(22) Date of filing: **14.11.79**

(54) **Semiconductor device including a diode and a bipolar transistor.**

(30) Priority: **15.11.78 JP 157063/78**

(43) Date of publication of application:
**11.06.80 Bulletin 80/12**

(45) Publication of the grant of the patent:
**05.09.84 Bulletin 84/36**

(84) Designated Contracting States:
**DE FR GB NL**

(56) References cited:
**GB-A-1 227 964**
**GB-A-1 280 022**
**GB-A-1 280 876**

**pp 59-67 of Integrated Circuit Design Principles
and Fabrication by RM.Warner
IBM TECHNICAL DISCLOSURE BULLETIN, vol.
8, no. 12, May 1966, New York, US B.A.
AGUSTA et al. "Component interconnection for
integrated circuits", pages 1843-1844**

(73) Proprietor: **FUJITSU LIMITED**
**1015, Kamikodanaka Nakahara-ku
Kawasaki-shi Kanagawa 211 (JP)**

(72) Inventor: **Enomoto, Hiromu**
**1-15-1225, Kawara-cho
Saiwai-ku Kawasaki-shi, Kanagawa 210 (JP)**
Inventor: **Yasuda, Yasushi**
**92, Oomaru
Inagi-shi, Tokyo 192-02 (JP)**
Inventor: **Ohmichi, Hitoshi**
**2223, Shukugawara
Tama-ku Kawasaki-shi, Kanagawa 214 (JP)**
Inventor: **Mitono, Yoshiharu**
**14-12, Sakuragaoka 1-chome
Setagaya-ku, Tokyo 156 (JP)**

(74) Representative: **Abbott, Leonard Charles et al
GILL JENNINGS & EVERY 53-64 Chancery Lane
London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

(58) References cited:
IBM TECHNICAL DISCLOSURE BULLETIN, vol.
15, no. 1, June 1972. New York US H.H.
BERGER et al. "Diistor", page 233
IBM TECHNICAL DISCLOSURE BULLETIN, vol.
19, no. 2, July 1976, New York US K.E. KROELL:
"Suppression of a parasitic SCR by ion
implantation", pages 543-544
SOLID STATE ELECTRONICS, vol. 19, no. 8,
August 1976, Oxford GB K.K. KROELL:
"Parasitic SCR between a Schottky diode and
an adjacent transistor", pages 711-714

## Description

This invention relates to a semiconductor device, and more particularly to an improved semiconductor device including a bipolar transistor and a diode which are connected to each other and formed in an isolated area of a semiconductor layer.

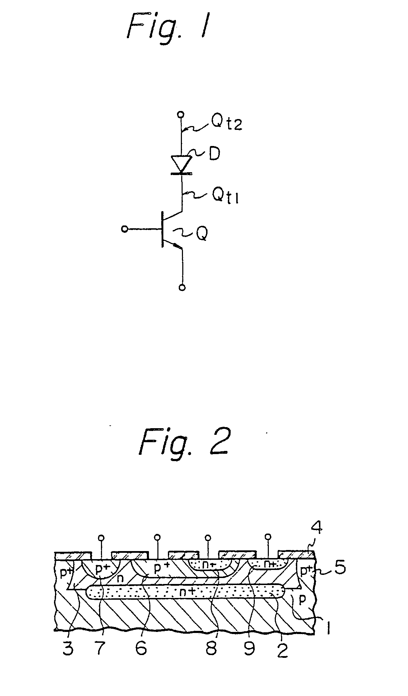

Generally, as can be seen in Fig. 1, a bipolar transistor Q and a PN junction diode (or a schottky barrier diode) are often connected in series for use in, for example, a TTL (transistor transistor logic) circuit. Fig. 1 is a schematic diagram of a semiconductor device consisting of a bipolar transistor and a diode. When an output of the transistor Q is taken out at a point indicated by the arrow $Qt_1$, the obtained voltage level is the voltage Vce between the collector and emitter of the transistor Q. When an output of the transistor Q is taken out at a point indicated by the arrow $Qt_2$, the obtained voltage level is the total voltage of the voltage Vce and the forward bias voltage Vf of the diode D.

In order to produce the semiconductor device illustrated in Fig. 1, the bipolar transistor Q and diode D have been formed in separate isolated areas, and then they have been connected with a conductor. Thus, since two isolated areas are required for producing the semiconductor device, it is difficult to produce a semiconductor device of a small size.

In the production of IC or LSI semiconductor devices including the above-mentioned semiconductor device comprised of a bipolar transistor and a diode, there was an attempt made to form the bipolar transistor and diode in one isolated area, whereby the area required for the semiconductor device could be further reduced (for example, it is possible to reduce the required area by 20 ~ 30% as compared with that for forming the semiconductor device in separate isolated areas). Fig. 2 is a cross-sectional view of a semiconductor device which is formed in an isolated area and corresponds to the diagram of Fig. 1. In Fig. 2, the reference numerals 1, 2, 3, 4 and 5 represent a p-type silicon semiconductor substrate, an $n^+$-type buried layer, an n-type epitaxially grown silicon semiconductor layer, a silicon dioxide insulating film and a surrounding $p^+$-type isolation region, respectively. Furthermore, the reference numerals 6, 7, 8 and 9 represent a $p^+$-type base region of the bipolar transistor, a $p^+$-type region for the diode, an $n^+$-type emitter region and an $n^+$-type collector contact region, respectively. Thus, the PN junction, comprised of the $p^+$-type region 7 and the n-type epitaxial semiconductor layer 3, forms a diode, and the base region 6, emitter region 8 and collector region (i.e. a part of the epitaxial semiconductor layer 3) form an NPN transistor in the isolated epitaxial semiconductor layer 3.

However, in such a structure, the region 7, the epitaxial semiconductor layer 3, the base region 6 and the emitter region 8 form a PNPN diode i.e. a thyristor, and it is easy to turn on the PNPN diode by a small current, e.g. a few micro amperes in the worst case, namely, a so-called PNPN diode effect occurs.

It is possible to form a schottky barrier diode instead of the above-mentioned PN junction diode. In this case, the semiconductor device, comprised of the schottky barrier diode and the above-mentioned transistor, functions normally at a small current, e.g. less than 3 mA, but the semiconductor device does not function normally, namely a PNPN diode is turned on, by a large current, e.g. more than 3 mA.

In Solid State Electronics, Vol. 19, No. 8, August 1976, pages 711 to 714, an article entitled "Parasitic SCR between Schottky diode and an adjacent transistor" recognises the problem of the parasitic effect in such a device. In page 714, the author recommends the insertion of isolation between the diode and the transistor to thereby suppress the diffusion of minority carriers between the two devices, to make the cross-section of the diffusion path between the diode and the transistor equal to zero. An example of an integrated circuit which reduces the parasitic effect is given by the same author in the IBM Technical Disclosure Bulletin, Vol. 19, No. 2, July 1976, entitled "Suppression of a Parasitic SCR by ion implantation", pages 543 to 544. Ion implantation-recombination centres are introduced between the diode and transistor, and are represented by impurity atoms.

IBM Technical Disclosure Bulletin, Vol. 15, No. 1 by Berger et al entitled Diistor at pages 233—234 shows a diistor consisting of a PN diode and an NPN transistor. A $p^+$ diffusion region in the form of a ring surrounds the $p^+$ diode terminal in order to suppress the diffusion of minority carriers. The $p^+$ ring is connected electrically to the collector terminal. The IBM Technical Disclosure Bulletin, Vol. 8, No. 12, May 1966, by Agusta et al, entitled "Component Interconnection for Integrated Circuits", pages 1843 to 1844, is also concerned with the same problem of preventing the latching of a parasitic SCR. In this disclosure, a $P^+$ isolation region 8 is inserted between the diode and the transistor, and extends vertically from the surface of the device to a bured $N^+$ layer 11 which is a sub-collector. The isolation region 8 is very effective for absorbing the minority carriers of the parasitic PNP transistor. The isolation region 8 is connected to the isolation region 7, and this device suffers from a low breakdown voltage between the surrounding isolation region 7 and the collector 9 of the transistor. There is also a large capacitance between the heavily-doped isolation region 8 and buried layer 11, resulting in a slow switching time.

The invention consists in a semiconductor device including a diode and a bipolar transistor which are connected to each other and formed in an isolated area (3) of a semiconductor layer of a first conductivity type formed on a semiconductor substrate (1) of the opposite conductivity type, the said isolated area (3) comprising a portion of the said layer that is surrounded by an isolation region (5) comprising a heavily doped region of the said opposite conductivity type extending from the surface of the said semiconductor layer at least to the said substrate (1), the said isolated area (3) serving as the collector of the said transistor and having a base region (6) of the said transistor formed therein of the said opposite conductivity type, and the said semiconductor device having a buried region (2) heavily doped with impurities of the first conductivity type and located between the said layer and the said substrate (1), the buried layer being separated from the said isolation region (5), characterized in that there is provided a diffusion region (10) of the said opposite conductivity type formed between the base region (6) of the said bipolar transistor and a region (7) of the said isolated area (3) where the said diode is formed, and which traverses the said isolated area to connect with the said isolation region (5), the diffusion region (10) being separated from the said buried region (2) by a portion of the said layer.

The invention will become more apparent from the detailed description of one embodiment of the invention set forth below, with reference to the accompanying drawings, in which:

Fig. 1 is a schematic diagram of a semiconductor device consisting of a diode and a bipolar transistor.

Fig. 2 is a cross-sectional view of a known semiconductor device which is formed in an isolated area and corresponds to the diagram of Fig. 1.

Fig. 3 is a cross-sectional view of a semiconductor device embodying the present invention which corresponds to the diagram of Fig. 1.

Fig. 4 is a plan view taken along line IV—IV of Fig. 3.

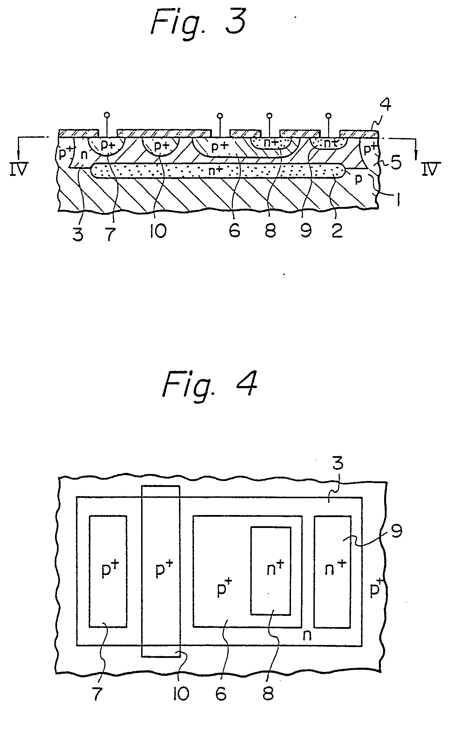

In Fig. 3, the reference numerals 1 through 9 represent the same parts as those represented by the reference numerals 1 through 9 in Fig. 2, respectively.

A difference between the semiconductor device according to the present invention in Figs. 3 and 4 and the semiconductor device in Fig. 2 is the formation of a $p^+$-type region 10 which is formed between the $p^+$-type base region 6 and the $p^+$-type region 7 and traverses the upper part of the isolated epitaxial semiconductor layer 3. It is preferable to make the depth of the $p^+$-type region 10 the same as that of the base region 6 and the $p^+$-type region 7 by forming these three regions simultaneously. The formed $p^+$-type region 10 prevents the formation of the above-mentioned parasitic PNPN diode (i.e. thyristor). Since the formed $P^+$-type region 10 is connected with the surrounding $P^+$-type isolation region 5 having the most negative potential, minority carriers arising at the $p^+$-type region 7 are almost all absorbed by the formed region 10 and hardly any flow into the $p^+$-type region 6.

It is possible to form a schottky barrier diode instead of the diode illustrated in Fig. 3. In this case, the semiconductor device comprised of the schottky barrier diode and the bipolar transistor can function normally at a large current, e.g. more than 100 mA.

The semiconductor device illustrated in Figs. 3 and 4 is produced as follows. The starting material is a p-type silicon semiconductor substrate 1. Donor impurity (e.g. P, As or Sb) is diffused into a part of the silicon substrate 1 to form an $n^+$-type buried layer 2. On the silicon substrate 1 an n-type epitaxial silicon semiconductor layer 3 is grown. A silicon dioxide film (not illustrated in Fig. 3) is formed on the epitaxial layer 3. A part of the silicon dioxide film is removed by a conventional photo etching process to expose a part of the epitaxial layer 3. The acceptor impurity (e.g. B, Ga or In) is diffused into the exposed part of the epitaxial layer 3 to form a $p^+$-type region 5, i.e. a surrounding isolation region. Thus, an isolated area, i.e. an isolated n-type epitaxial silicon semiconductor layer 3 is formed. After removing the remaining silicon dioxide film, another silicon dioxide film is re-formed on the entire surface of the epitaxial layer and then three parts of the formed silicon dioxide film are removed by a photo etching process. The acceptor impurity is diffused into three exposed parts of the isolated area 3 to form a $p^+$-type base region 6 of a bipolar transistor, a $p^+$-type region 7 for a diode and a $p^+$-type region 10 which lies between the regions 6 and 7 across the isolated area 3. After removing the remaining silicon dioxide film, a silicon dioxide film is again re-formed and then two parts of this re-formed silicon dioxide film are removed by a photo etching process. A donor impurity is diffused into the two exposed parts of the isolated area 3 to form an $n^+$-type emitter region 8 and an $n^+$-type collector contact region 9 of the bipolar transistor. After removing the remaining silicon dioxide film, a silicon dioxide insulating film 4 is re-formed on the entire surface of the isolated area 3. Four parts of the formed silicon dioxide film 4 are removed by a photo etching process and then a conductor film, e.g. Al is deposited on the entire top surface by a conventional evaporation process. Finally, the deposited conductor film is etched to form a desired pattern of contacts by a photo etching process.

It is possible to form a schottky barrier diode instead of the diode formed by the above-mentioned procedure by a conventional technique.

It will be obvious to those skilled in the art that the present invention is not restricted to the above-described embodiments of the present invention, and that many variations are possible for those skilled in the art without departing from the scope of the present invention.

## Claims

1. A semiconductor device including a diode and a bipolar transistor which are connected to each other and formed in an isolated area (3) of a semiconductor layer of a first conductivity type formed on a semiconductor substrate (1) of the opposite conductivity type, the said isolated area (3) comprising a portion of the said layer that is surrounded by an isolation region (5) comprising a heavily doped region of the said opposite conductivity type extending from the surface of the said semiconductor layer at least to the said substrate (1), the said isolated area (3) serving as the collector of the said transistor and having a base region (6) of the said transistor formed therein of the said opposite conductivity type, and the said semiconductor device having a buried region (2) heavily doped with impurities of the first conductivity type and located between the said layer and the said substrate (1), the buried layer being separated from the said isolation region (5), characterized in that there is provided a diffusion region (10) of the said opposite conductivity type formed between the base region (6) of the said bipolar transistor and a region (7) of the said isolated area (3) where the said diode is formed, and which traverses the said isolated area to connect with the said isolation region (5), the diffusion region (10) being separated from the said buried region (2) by a portion of the said layer.

2. A semiconductor device according to claim 1, characterized in that the said diffusion region (10) has the same depth as that of the said base region (6).

3. A semiconductor device according to claim 1 or 2, characterized in that said diode is a PN junction diode.

4. A semiconductor device according to claim 1 or 2, characterized in that said diode is a Schottky barrier diode.

5. A semiconductor device according to any preceding claim characterized in that said first conductivity type is N type.

6. A semiconductor device according to any preceding claim characterized in that said bipolar transistor is a NPN type.

## Revendications

1. Dispositif à semiconducteur comportant une diode et un transistor bijonction qui sont connectés l'un à l'autre et sont formés dans une aire isolée (3) d'une couche semiconductrice d'un premier type de conductivité formée sur un substrat semiconducteur (1) du type opposé de conductivité, ladite aire isolée (3) comprenant une partie de ladite couche qui est entourée par une région d'isolation (5) comprenant une région fortement dopée dudit type opposé de conductivité s'étendant de la surface de ladite couche semiconductrice au moins jusqu'au dit substrat (1), ladite aire isolée (3) faisant fonction de collecteur dudit transistor et comportant une région de base (6) dudit transistor qui est dotée dudit type opposé de conductivité, et ledit dispositif à semiconducteur possédant une région enterrée (2) qui est fortement dopée à l'aide d'impuretés du premier type de conductivité et qui est située entre ladite couche et ledit substrat (1), la couche enterrée étant séparée de ladite région d'isolation (5), caractérisé en ce qu'il existe une région de diffusion (10) dudit type opposé de conductivité qui est formée entre la région de base (6) dudit transistor bijonction et une région (7) de ladite aire isolée (3) où ladite diode est formée et qui traverse ladite aire isolée afin de se connecter à ladite région d'isolation (5), la région de diffusion (10) étant séparée de ladite région enterrée (2) par une partie de ladite couche.

2. Dispositif à semiconducteur selon la revendication 1, caractérisé en ce que ladite région de diffusion (10) possède la même profondeur que ladite région de base (6).

3. Dispositif à semiconducteur selon la revendication 1 ou 2, caractérisé en ce que ladite diode est une diode à jonction PN.

4. Dispositif à semiconducteur selon la revendication 1 ou 2, caractérisé en ce que ladite diode est une diode à barrière de Schottky.

5. Dispositif à semiconducteur selon l'une quelconque des revendications précédentes, caractérisé en ce que ledit premier type de conductivité est le type N.

6. Dispositif à semiconducteur selon l'une quelconque des revendications précédentes, caractérisé en ce que ledit transistor bijonction est un transistor de type NPN.

## Patentansprüche

1. Halbleitervorrichtung mit einer Diode und einem Bipolartransistor, die miteinander verbunden und in einem isolierten Bereich (3) einer Halbleiterschicht von einem ersten Leitfähigkeitstyp gebildet sind, welche auf einem Halbleitersubstrat (1) von entgegengesetztem Leitfähigkeitstyp gebildet ist.

bei welcher der genannte isolierte Bereich (3) einen Abschnitt der genannten Schicht umfaßt, welche von einem Isolierbereich (5) umgeben ist, der einen stark dotierten Bereich von dem genannten entgegengesetzten Leitfähigkeitstyp umfaßt, der sich von der Oberfläche der genannten Halbleiterschicht wenigstens zu dem genannten Substrat (1) erstreckt,

wobei der genannte isolierte Bereich (3) als Kollektor des genannten Transistors dient und einen Basisbereich (6) des genannten dar in gebildeten Transistors vom entgegengesetzen Leitfähigkeitstyp hat,

und die genannte Halbleitervorrichtung einen vergrabenen Bereich (2) aufweist, der stark mit Verunreinigungen des ersten Leitfähigkeitstyps dotiert ist und zwischen der genannten Schicht und dem genannten Substrat (1) angeordnet ist, wobei die vergrabene Schicht von dem genannten Isolierbereich (5) getrennt ist, dadurch gekennzeichnet,

daß ein Diffusionsbereich (10) vom genannten entgegengesetzten Leitfähigkeitstyp zwischen dem Basisbereich (6) des genannten Bipolartransistors und einem Bereich (7) des genannten isolierten Bereichs (3) gebildet ist, wo die genannte Diode gebildet ist, und welcher den genannten isolierten Bereich überquert, um mit dem Isolierbereich (5) zu kontaktieren,

wobei der Diffusionsbereich (10) von dem genannten vergrabenen Bereich (2) durch einen Abschnitt der genannten Schicht getrennt ist.

2. Halbleitervorrichtung nach Anspruch 1, dadurch gekennzeichnet, daß der genannte Diffusionsbereich (10) dieselbe Tiefe wie der genannte Basisbereich (6) hat.

3. Halbleitervorrichtung nach Anspruch 1 oder 2, dadurch gekennzeichnet, daß die genannte Diode eine PN-Grenzschichtdiode ist.

4. Halbleitervorrichtung nach Anspruch 1 oder 2, dadurch gekennzeichnet, daß die genannte Diode eine Schottky-Sperrschichtdiode ist.

5. Halbleitervorrichtung nach einem der vorhergehenden Ansprüche, dadurch gekennzeichnet, daß der genannte erste Leitfähigkeitstyp der N-Typ ist.

6. Halbleitervorrichtung nach einem der vorhergehenden Ansprüche, dadurch gekennzeichnet, daß der genannte Bipolartransistor ein NPN-Transistor ist.

## Fig. 1

## Fig. 2

Fig. 3

Fig. 4